# EUROPEAN PATENT APPLICATION

(11) **EP 4 411 585 A1**
(43) Date of publication of application: **07.08.2024**
(21) Application number: 24153271.2
(22) Date of filing: 22.01.2024
(51) Int. Cl.: G06F 30/394

(54) **DEVICES WITH IMPROVED INTEGRITY OF DIGITAL SIGNALS**

(30) Priority: 03.02.2023 US 202318164307
(71) Applicant: Apple Inc., Cupertino CA 95014 (US)
(72) Inventor: CHANDAKA, Venu, Cupertino, 95014 (US); Mulage, Preeti S., Cupertino, 95014 (US)
(74) Representative: Barton, Russell Glen

(57) **Abstract**

As the complexity of integrated circuits (ICs) increase (e.g., more sophisticated circuit designs and/or more circuit components integrated into the ICs), digital routing channels connecting various circuit components may occupy more chip area to prevent certain interferences (e.g., interference caused by a channel crosstalk or coupling between adjacent digital routing channels), resulting in certain problems, such as reduced efficiency of chip area usage and increased power consumption. To solve such problems, inverter staggering circuits and/or coaxial shielding of digital routing channels may be used in the ICs to mitigate the interferences. The inverter staggering circuits and/or coaxial shielding may improve the robustness of digital signals transmitted via the digital routing channels with reduced interferences, resulting in enhanced signal integrity, chip area utilization, power saving, and the like.

## Description

### BACKGROUND

The present disclosure relates generally to signal quality enhancements, and more specifically to improving digital signal integrity in integrated circuits.

User devices (e.g., mobile phones, smart watches, tablets, laptops) may include a variety of integrated circuits (ICs) made of semiconductor materials (e.g., silicon). For instance, the ICs in the user devices may include large numbers of diodes, transistors (e.g., metal-oxide-semiconductor field-effect transistors (MOSFETs)), and logic gates in small chips. Using the ICs may result in smaller and faster circuits in the user devices than circuits constructed of discrete electronic components. However, as the complexity of the ICs increase, certain components (e.g., digital routing channels) may occupy more areas on the chips, resulting in reduced efficiency of chip area usage and increased power consumption. This may create challenges for the IC design to maintain desired digital signal qualities while improving the efficiency of chip area usage and reducing the power consumption of the ICs in the user devices.

### SUMMARY

A summary of certain embodiments disclosed herein is set forth below. It should be understood that these aspects are presented merely to provide the reader with a brief summary of these certain embodiments and that these aspects are not intended to limit the scope of this disclosure. Indeed, this disclosure may encompass a variety of aspects that may not be set forth below.

In one embodiment, an integrated circuit includes multiple circuit components and multiple routing channels coupled to the multiple circuit components. The integrated circuit also includes a first set of inverters disposed on a first routing channel of the multiple routing channels in a longitudinal direction and a second set of inverters disposed on a second routing channel of the multiple routing channels in the longitudinal direction. Each inverter of the second set of inverters is non-overlapping with each inverter of the first set of inverters in a transverse direction.

In another embodiment, an integrated circuit includes multiple circuit components and multiple routing channels coupled to the multiple circuit components. The integrated circuit also includes multiple ground or negative supply signal lines. A respective ground or negative supply signal line of the multiple ground or negative supply signal lines is disposed between two or more routing channels of the multiple routing channels in the longitudinal direction or a transverse direction.

In yet another embodiment, an electronic device includes a processor, a transceiver, and multiple routing channels coupling the processor to the transceiver. The electronic device also includes a first set of inverters disposed on a first routing channel of the multiple routing channels in a longitudinal direction and a second set of inverters disposed on a second routing channel of the multiple routing channels in the longitudinal direction. Each inverter of the second set of inverters is non-overlapping with each inverter of the first set of inverters in a transverse direction. The electronic device further includes

Various refinements of the features noted above may exist in relation to various aspects of the present disclosure. Further features may also be incorporated in these various aspects as well. These refinements and additional features may exist individually or in any combination. For instance, various features discussed below in relation to one or more of the illustrated embodiments may be incorporated into any of the above-described aspects of the present disclosure alone or in any combination. The brief summary presented above is intended only to familiarize the reader with certain aspects and contexts of embodiments of the present disclosure without limitation to the claimed subject matter.

### BRIEF DESCRIPTION OF THE DRAWINGS

Various aspects of this disclosure may be better understood upon reading the following detailed description and upon reference to the drawings described below in which like numerals refer to like parts.
FIG. 1 is a block diagram of an electronic device, according to embodiments of the present disclosure;
FIG. 2 is a functional diagram of the electronic device of FIG. 1, according to embodiments of the present disclosure;
FIG. 3 is a block diagram of a multi-chip package (MCP) including a system-on-chip (SoC) chip and an auxiliary chip that may be used in the electronic device of FIG. 1, according to embodiments of the present disclosure;
FIG. 4 is a block diagram of a first integrated circuit having a main digital engine, multiple Intellectual Property (IP) cores, and digital routing channels that may be used in the multi-chip package of FIG. 3, according to embodiments of the present disclosure;
FIG. 5 is a block diagram of a second integrated circuit having the main digital engine, the multiple IP cores, and the digital routing channels that may be used in the multi-chip package of FIG. 3, according to embodiments of the present disclosure;
FIG. 6 is a schematic diagram of an interference caused by crosstalk between adjacent routing channels that may occur in the integrated circuits of FIGS 4-5, according to embodiments of the present disclosure;
FIG. 7 is a schematic diagram of using a buffering scheme for digital signal transmissions, according to embodiments of the present disclosure;
FIG. 8 is a schematic diagram of certain signal interferences caused by crosstalk that may occur in the digital signal transmissions using the buffering scheme of FIG. 7, according to embodiments of the present disclosure;
FIG. 9 is a schematic diagram of a first implementation of a channel crosstalk suppression using inverter-staggering circuits that may solve the signal interferences of FIG. 8, according to embodiments of the present disclosure;
FIG. 10 is a schematic diagram of transmitted digital signals in the first implementation of the channel crosstalk suppression using the inverter-staggering circuits of FIG. 9, according to embodiments of the present disclosure;
FIG. 11 is a schematic diagram of signal integrity testing examples using the inverter-staggering circuits of FIG. 9, according to embodiments of the present disclosure;
FIG. 12 is a schematic diagram of a second implementation of the channel crosstalk suppression using coaxial shielding that may solve the signal interferences of FIG. 8, according to embodiments of the present disclosure;
FIG. 13 is a schematic diagram of signal integrity testing examples using the coaxial shielding of FIG. 12, according to embodiments of the present disclosure;
FIG. 14 is a schematic diagram of a third implementation of the channel crosstalk suppression using a combination of the inverter-staggering circuits of FIG. 9 and the coaxial shielding of FIG. 12, according to embodiments of the present disclosure; and
FIG. 15 is a schematic diagram of signal integrity testing examples using the combination of the inverter-staggering circuits and the coaxial shielding of FIG. 14, according to embodiments of the present disclosure.

### DETAILED DESCRIPTION OF SPECIFIC EMBODIMENTS

One or more specific embodiments will be described below. In an effort to provide a concise description of these embodiments, not all features of an actual implementation are described in the specification. It should be appreciated that in the development of any such actual implementation, as in any engineering or design project, numerous implementation-specific decisions must be made to achieve the developers' specific goals, such as compliance with system-related and business-related constraints, which may vary from one implementation to another. Moreover, it should be appreciated that such a development effort might be complex and time consuming, but would nevertheless be a routine undertaking of design, fabrication, and manufacture for those of ordinary skill having the benefit of this disclosure.

When introducing elements of various embodiments of the present disclosure, the articles "a," "an," and "the" are intended to mean that there are one or more of the elements. The terms "comprising," "including," and "having" are intended to be inclusive and mean that there may be additional elements other than the listed elements. Additionally, it should be understood that references to "one embodiment" or "an embodiment" of the present disclosure are not intended to be interpreted as excluding the existence of additional embodiments that also incorporate the recited features. Furthermore, the particular features, structures, or characteristics may be combined in any suitable manner in one or more embodiments. Use of the terms "approximately," "near," "about," "close to," and/or "substantially" should be understood to mean including close to a target (e.g., design, value, amount), such as within a margin of any suitable or contemplatable error (e.g., within 0.1 % of a target, within 1% of a target, within 5% of a target, within 10% of a target, within 25% of a target, and so on). Moreover, it should be understood that any exact values, numbers, measurements, and so on, provided herein, are contemplated to include approximations (e.g., within a margin of suitable or contemplatable error) of the exact values, numbers, measurements, and so on. Additionally, the term "set" may include one or more. That is, a set may include a unitary set of one member, but the set may also include a set of multiple members.

This disclosure is directed to an integrated circuit (IC) (e.g., a system-on-chip (SoC) chip) integrated with inverter staggering circuits and/or coaxial shielding of digital routing channels. As the complexity of the SoC chip increases (e.g., more sophisticated circuit designs and/or more circuit components integrated into the SoC chip), the digital routing channels may occupy more chip area to prevent certain interferences (e.g., caused by channel crosstalk or coupling between adjacent digital routing channels), resulting in reduced efficiency of chip area usage and increased power consumption. The inverter staggering circuits and/or coaxial shielding may improve the robustness of digital signals transmitted via the digital routing channels with reduced interferences, resulting in enhanced signal integrity, chip area utilization, power saving, and so on.

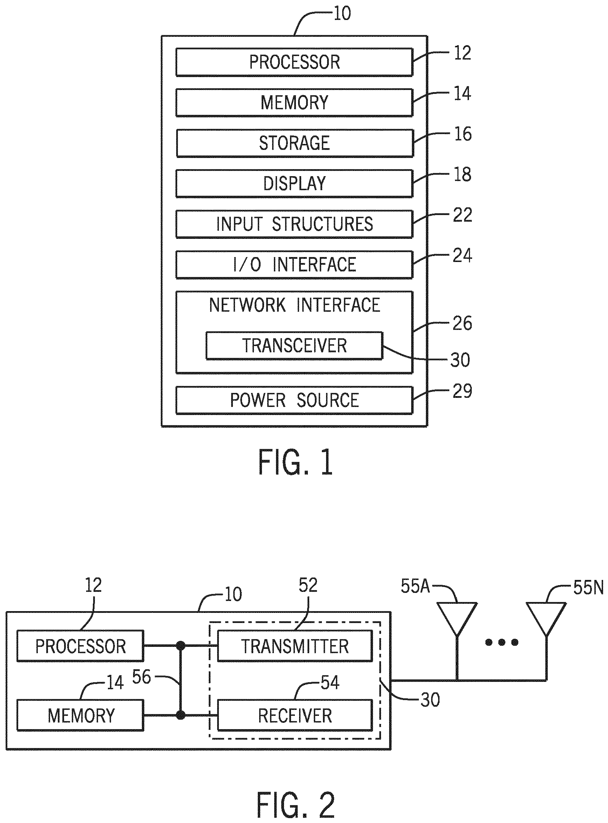

With the foregoing in mind, FIG. 1 is a block diagram of an electronic device 10. The electronic device 10 may include, among other things, one or more processors 12 (collectively referred to herein as a single processor for convenience, which may be implemented in any suitable form of processing circuitry), memory 14, nonvolatile storage 16, a display 18, input structures 22, an input/output (I/O) interface 24, a network interface 26, and a power source 29. The various functional blocks shown in FIG. 1 may include hardware elements (including circuitry), software elements (including machine-executable instructions) or a combination of both hardware and software elements (which may be referred to as logic). The processor 12, memory 14, the nonvolatile storage 16, the display 18, the input structures 22, the input/output (I/O) interface 24, the network interface 26, and/or the power source 29 may each be communicatively coupled directly or indirectly (e.g., through or via another component, a communication bus, a network) to one another to transmit and/or receive signals between one another. It should be noted that FIG. 1 is merely one example of a particular implementation and is intended to illustrate the types of components that may be present in the electronic device 10.

By way of example, the electronic device 10 may include any suitable computing device, including a desktop or notebook computer (e.g., in the form of a MacBook^{®}, MacBook^{®} Pro, MacBook Air^{®}, iMac^{®}, Mac^{®} mini, or Mac Pro^{®} available from Apple Inc. of Cupertino, California), a portable electronic or handheld electronic device such as a wireless electronic device or smartphone (e.g., in the form of a model of an iPhone^{®} available from Apple Inc. of Cupertino, California), a tablet (e.g., in the form of a model of an iPad^{®} available from Apple Inc. of Cupertino, California), a wearable electronic device (e.g., in the form of an Apple Watch^{®} by Apple Inc. of Cupertino, California), and other similar devices. It should be noted that the processor 12 and other related items in FIG. 1 may be embodied wholly or in part as software, hardware, or both. Furthermore, the processor 12 and other related items in FIG. 1 may be a single contained processing module or may be incorporated wholly or partially within any of the other elements within the electronic device 10. The processor 12 may be implemented with any combination of general-purpose microprocessors, microcontrollers, digital signal processors (DSPs), field programmable gate array (FPGAs), programmable logic devices (PLDs), controllers, state machines, gated logic, discrete hardware components, dedicated hardware finite state machines, or any other suitable entities that may perform calculations or other manipulations of information. The processors 12 may include one or more application processors, one or more baseband processors, or both, and perform the various functions described herein.

In the electronic device 10 of FIG. 1, the processor 12 may be operably coupled with the memory 14 and the nonvolatile storage 16 to perform various algorithms. Such programs or instructions executed by the processor 12 may be stored in any suitable article of manufacture that includes one or more tangible, computer-readable media. The tangible, computer-readable media may include the memory 14 and/or the nonvolatile storage 16, individually or collectively, to store the instructions or routines. The memory 14 and the nonvolatile storage 16 may include any suitable articles of manufacture for storing data and executable instructions, such as random-access memory, read-only memory, rewritable flash memory, hard drives, and optical discs. In addition, programs (e.g., an operating system) encoded on such a computer program product may also include instructions that may be executed by the processor 12 to enable the electronic device 10 to provide various functionalities.

In certain embodiments, the display 18 may facilitate users to view images generated on the electronic device 10. In some embodiments, the display 18 may include a touch screen, which may facilitate user interaction with a user interface of the electronic device 10. Furthermore, it should be appreciated that, in some embodiments, the display 18 may include one or more liquid crystal displays (LCDs), light-emitting diode (LED) displays, organic light-emitting diode (OLED) displays, active-matrix organic light-emitting diode (AMOLED) displays, or some combination of these and/or other display technologies.

The input structures 22 of the electronic device 10 may enable a user to interact with the electronic device 10 (e.g., pressing a button to increase or decrease a volume level). The I/O interface 24 may enable electronic device 10 to interface with various other electronic devices, as well as the network interface 26. In some embodiments, the I/O interface 24 may include an I/O port for a hardwired connection for charging and/or content manipulation using a standard connector and protocol, such as the Lightning connector provided by Apple Inc. of Cupertino, California, a universal serial bus (USB), or other similar connector and protocol. The network interface 26 may include, for example, one or more interfaces for a personal area network (PAN), such as an ultra-wideband (UWB) or a BLUETOOTH^{®} network, a local area network (LAN) or wireless local area network (WLAN), such as a network employing one of the IEEE 802.11x family of protocols (e.g., WI-FI^{®}), and/or a wide area network (WAN), such as any standards related to the Third Generation Partnership Project (3GPP), including, for example, a 3^{rd} generation (3G) cellular network, universal mobile telecommunication system (UMTS), 4^{th} generation (4G) cellular network, Long Term Evolution ^{®} (LTE) cellular network, Long Term Evolution License Assisted Access (LTE-LAA) cellular network, 5^{th} generation (5G) cellular network, and/or New Radio (NR) cellular network, a 6^{th} generation (6G) or greater than 6G cellular network, a satellite network, a non-terrestrial network, and so on. In particular, the network interface 26 may include, for example, one or more interfaces for using a cellular communication standard of the 5G specifications that include the millimeter wave (mmWave) frequency range (e.g., 24.25-300 gigahertz (GHz)) that defines and/or enables frequency ranges used for wireless communication. The network interface 26 of the electronic device 10 may allow communication over the aforementioned networks (e.g., 5G, Wi-Fi, LTE-LAA, and so forth).

The network interface 26 may also include one or more interfaces for, for example, broadband fixed wireless access networks (e.g., WIMAX^{®}), mobile broadband Wireless networks (mobile WIMAX^{®}), asynchronous digital subscriber lines (e.g., ADSL, VDSL), digital video broadcasting-terrestrial (DVB-T^{®}) network and its extension DVB Handheld (DVB-H^{®}) network, ultra-wideband (UWB) network, alternating current (AC) power lines, and so forth.

As illustrated, the network interface 26 may include a transceiver 30. In some embodiments, all or portions of the transceiver 30 may be disposed within the processor 12. The transceiver 30 may support transmission and receipt of various wireless signals via one or more antennas, and thus may include a transmitter and a receiver. The power source 29 of the electronic device 10 may include any suitable source of power, such as a rechargeable lithium polymer (Li-poly) battery and/or an alternating current (AC) power converter.

FIG. 2 is a functional diagram of the electronic device 10 of FIG. 1, according to embodiments of the present disclosure. As illustrated, the processor 12, the memory 14, the transceiver 30, a transmitter 52, a receiver 54, and/or antennas 55 (illustrated as 55A-55N, collectively referred to as an antenna 55) may be communicatively coupled directly or indirectly (e.g., through or via another component, a communication bus, a network) to one another to transmit and/or receive signals between one another.

The electronic device 10 may include the transmitter 52 and/or the receiver 54 that respectively enable transmission and reception of signals between the electronic device 10 and an external device via, for example, a network (e.g., including base stations or access points) or a direct connection. As illustrated, the transmitter 52 and the receiver 54 may be combined into the transceiver 30. The electronic device 10 may also have one or more antennas 55A-55N electrically coupled to the transceiver 30. The antennas 55A-55N may be configured in an omnidirectional or directional configuration, in a single-beam, dual-beam, or multi-beam arrangement, and so on. Each antenna 55 may be associated with one or more beams and various configurations. In some embodiments, multiple antennas of the antennas 55A-55N of an antenna group or module may be communicatively coupled to a respective transceiver 30 and each emit radio frequency signals that may constructively and/or destructively combine to form a beam. The electronic device 10 may include multiple transmitters, multiple receivers, multiple transceivers, and/or multiple antennas as suitable for various communication standards. In certain embodiments, the transmitter 52 and the receiver 54 may transmit and receive information via other wired or wireline systems or means.

As illustrated, the various components of the electronic device 10 may be coupled together by a bus system 56. The bus system 56 may include a data bus, for example, as well as a power bus, a control signal bus, and a status signal bus, in addition to the data bus. The components of the electronic device 10 may be coupled together or accept or provide inputs to each other using some other mechanism.

In certain embodiments, the bus system 56 may include different bus lines (e.g., digital routing channels). For example, the bus system 56 may include data bus lines, address bus lines, and control bus lines. Data communications over each bus line may be performed in cooperation with other bus lines. For instance, the data bus line may include a signal line for exchanging data between a CPU (e.g., the processor 12) and a memory unit (e.g., the memory 14), between the CPU and an I/O unit (e.g., the I/O interface 24), or between the I/O unit and a network unit (e.g., the network interface 26).

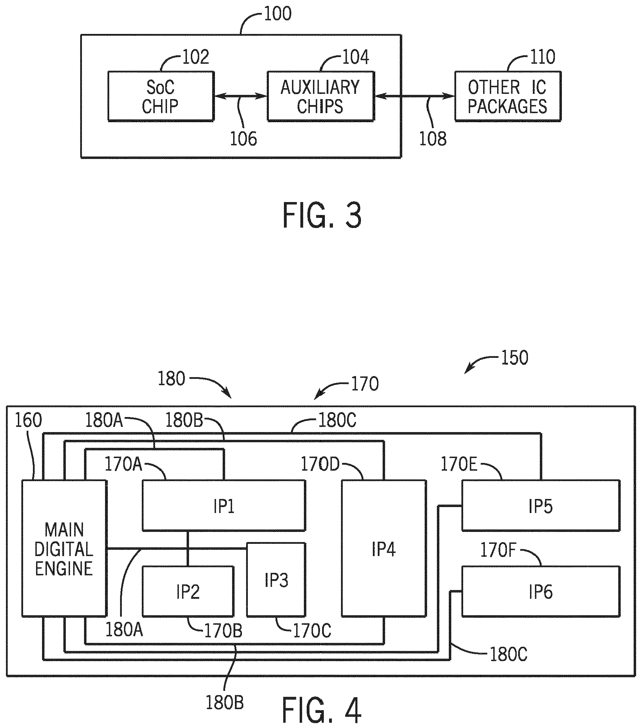

FIG. 3 is a block diagram of an integrated circuit (IC) package 100 (e.g., a multi-chip package (MCP)) including a system-on-chip (SoC) chip 102 and an auxiliary chip 104 that may be used in the electronic device 10 of FIG. 1. The SoC chip 102 may include the CPU (e.g., the processor 12) and other components (e.g., a system memory that may include at least a portion of the memory 14, peripherals such as a graphics processing unit (GPU), neural network circuitry, radio modems (for Bluetooth^{®} or Wi-Fi) such as the transceiver 30, and so on). The auxiliary chip 104 may be used to support the SoC chip 102. For example, the auxiliary chip 104 may include a network I/O chip (e.g., the network interface 26) that provides high bandwidth throughput for the SoC chip 102 to and/or from other IC packages 110. The auxiliary chip 104 may be developed by a third-party supplier, or by a different part of the same company that manufactures the SoC chip 102. The other IC packages 110 may include similar SoC chip(s) as the SoC chip 102 and/or similar auxiliary chip(s) as the auxiliary chip 104 and/or different die entirely.

A link 106 (e.g., including one or more digital routing channels or bus lines) provides interconnection and communication between the SoC chip 102 and the auxiliary chip 104. For example, the link 106 may include a high-speed chip-to-chip interconnect bus (e.g., a parallel data bus). The link 106 may couple the processor 12 to the transceiver 30. A link 108 (e.g., including one or more additional digital routing channels or bus lines) provides interconnection and communication between the IC package 100 and the other IC packages 110. For example, the link 108 may include an optical link and/or another suitable link type for providing high bandwidth and low latency network IO between the package 100 and the other IC packages 110.

With the proceeding in mind, FIG. 4 is a block diagram of a first integrated circuit (IC) 150 having a main digital engine 160, multiple Intellectual Property (IP) cores 170, and digital routing channels 180 that may be used in the multi-chip package 100 and the other IC packages 110 of FIG. 3. The main digital engine 160 may include a system-on-chip (SoC) chip (e.g., SoC chip 102). The SoC chip may include an integrated circuit that integrates a variety of components of an electronic system or device (e.g., the electronic device 10). The components may include a central processing unit (CPU) (e.g., the processor 12), memory interfaces (e.g., a system memory that may include at least a portion of the memory 14), on-chip input/output devices and/or interfaces (e.g., the input structures 22), and other components such as a graphics processing unit (GPU). The multiple Intellectual Property (IP) cores 170 (e.g., IP cores 170A-E) may include other input/output devices and/or interfaces (e.g., the I/O interface 24, the network interface 26, separate wireless modems), secondary storage interfaces (e.g., the storage 16, other dedicated and physically separate memory and secondary storage chips). The integrated circuit and the variety of components may be fabricated on a single substrate or microchip. In certain embodiments, the separate memory and secondary storage chips may be disposed on top of the SoC chip (e.g., a package on package (PoP) configuration), or be placed close to the SoC chip.

The digital routing channels 180 (e.g., digital routing channels 180A-C) provide connections and signal communications between the main digital engine 160 and multiple Intellectual Property (IP) cores 170. The digital routing channels 180 may transmit various signal, such as digital signals, analog signals, and mixed signal. The lengths of the digital routing channels 180 may vary depending on the relative distances between the main digital engine 160 and multiple Intellectual Property (IP) cores 170. For example, the digital routing channel 180A connecting the main digital engine 160 and the IP core 170A (IP1) (or the IP core 170B (IP2), the IP core 170C (IP3)) may be shorter than the digital routing channel 180B connecting the main digital engine 160 and the IP core 170D (IP4), and the digital routing channel 180C connecting the main digital engine 160 and the IP core 170E (IP5) (or the IP core 170F (IP6)).

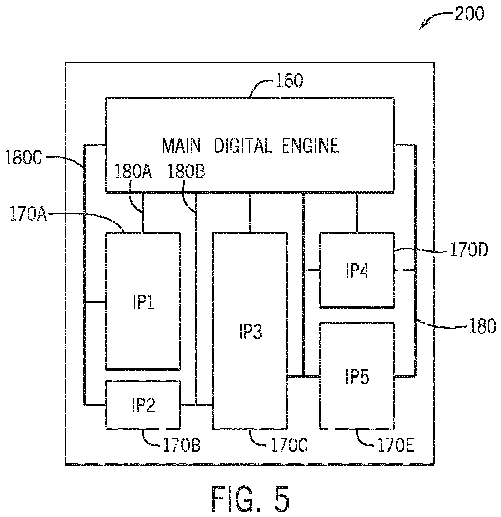

In certain embodiments, different integrated circuit layouts may be used in the electronic device 10. For example, FIG. 5 is a block diagram of a second integrated circuit (IC) 200 having the main digital engine 160 (e.g., the SoC chip 102 including the variety of components of the electronic device 10, such as the processor 12, the system memory that may include at least a portion of the memory 14, the input structures 22, and other components such as the graphics processing unit (GPU)), the multiple IP cores 170 (e.g., the IP cores 170A-E that may include the I/O interface 24, the network interface 26, separate wireless modems, secondary storage interfaces (e.g., the storage 16, other dedicated and physically separate memory and secondary storage chips), and the digital routing channels 180 that may be used in the multi-chip package 100 and/or the other IC packages 110 of FIG. 3. The main digital engine 160 may be fabricated on a single substrate or microchip. In certain embodiments, the separate memory and secondary storage chips may be disposed on top of the SoC chip (e.g., a package on package (PoP) configuration), or be placed close to the SoC chip.

The digital routing channels 180 (e.g., digital routing channels 180A-C) provide connections and signal communications between the main digital engine 160 and multiple Intellectual Property (IP) cores 170. The digital routing channels 180 illustrated in the second integrated circuit 200 may be different (e.g., with respect to layout, length) from the digital routing channels 180 illustrated in the first integrated circuit 150. For example, digital routing channels 180 (including 180A-C) illustrated in the second integrated circuit 200 may have shorter lengths in comparison to the corresponding digital routing channels 180 illustrated in the first integrated circuit 150, resulting a relative more centralized integrate circuit layout. The lengths of the digital routing channels 180 may vary depending on the relative distances between the main digital engine 160 and multiple Intellectual Property (IP) cores 170.

In certain cases, the SoC chips (e.g., the SoC chip 102), may include hundreds of digital routing channels routing from one part (e.g., the main digital engine 160) of the SoC chip to another part (e.g., the IPs 170). The digital routing channels may transmit various signals over distances, for example, more than tens of millimeters depending on the size of the SoC chip. The digital routing channels may be disposed in the SoC chip in particular ways (e.g., patterns, geometries, layouts) such that the signal integrity is maintained while the signals are transmitted through the digital routing channels. In such ways, certain functional errors (e.g., signal glitches caused by inter-channel interferences) may be avoided or reduced. A limit (e.g., a threshold spacing or distance) on the minimum spacing between two adjacent digital routing lines may be used to regulate the layout of the digital routing channels in the SoC chip. For example, the threshold spacing or distance may limit the minimum spacing between two adjacent digital routing lines to be a factor 5 (or bigger) larger than a width of each adjacent digital routing line.

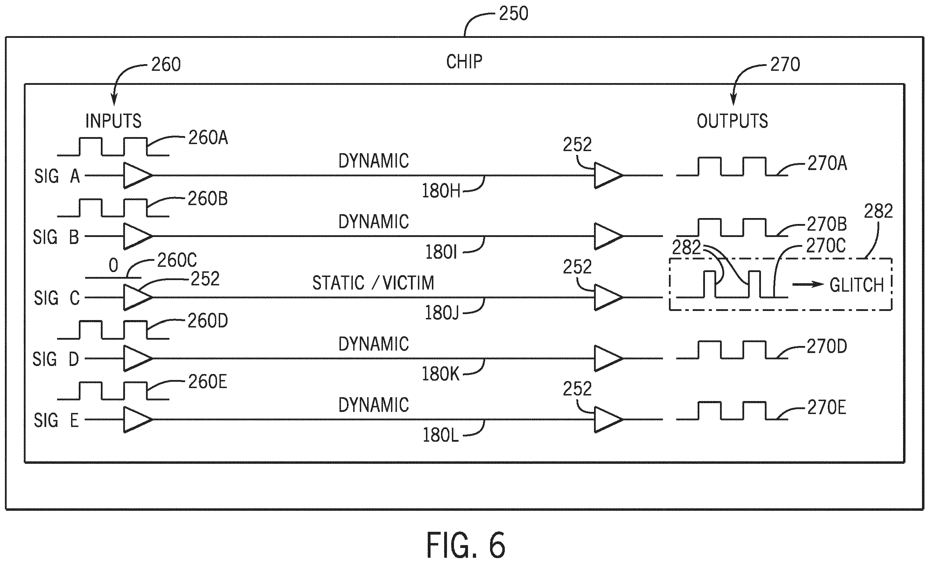

As the complexity of the integrated circuits (ICs, such as the IC 150 or IC 200) increase (e.g., more sophisticated circuit designs and more circuit components (e.g., IP cores 170) integrated into the ICs), certain components (e.g., the digital routing channels 180) may occupy more areas on the ICs (or chips). For instance, the digital routing channels may occupy more chip area to prevent certain undesired interferences (e.g., interference caused by a channel crosstalk or coupling between adjacent digital routing channels), resulting in reduced efficiency of chip area usage and increased power consumption. This may create challenges for the IC design to maintain desired digital signal qualities (e.g., signal integrity) while improving the efficiency of chip area usage and reducing the power consumption of the ICs in the electronic device 10. The embodiments described below with respect to FIGS. 6-15 illustrate systems and methods of using integrated circuits (ICs) (e.g., system-on-chips (SoCs)) integrated with inverter staggering circuits and/or coaxial shielding of digital routing channels to improve the robustness of digital signals transmitted via the digital routing channels 180 with reduced interferences, resulting in enhanced signal integrity, chip area utilization, power saving, and so on.

With this in mind, FIG. 6 is a schematic diagram of an interference caused by crosstalk between adjacent digital routing channels (e.g., the digital routing channels 180) that may occur in the integrated circuits (e.g., ICs 150 and 200) of FIGS 4-5. As illustrated, an integrated circuit (IC) portion 250 of the IC 150 includes five digital routing channels adjacent to each other, including digital routing channels 180H-L. The IC 150 includes buffers 252 for signal transmission via the digital routing channels 180H-L. The digital routing channels 180H-L may transmit similar or different input digital signals 260 and similar or different output digital signals 270.

For example, the digital routing channels 180H may transmit a dynamic digital input signal 260A through two of the buffers 252 and transmit a corresponding dynamic digital output signal 270A to another component of the IC 150. Similarly, the digital routing channels 180I, 180K, and 180L may transmit dynamic digital input signal 260B, 260D, and 260E through the buffers 252 and transmit corresponding dynamic digital output signal 270B, 270D, and 270E to respective components of the IC 150. The digital routing channels 180J may transmit a static digital input signal 260C (e.g., a zero volt signal) through two of the buffers 252 and transmit a corresponding digital output signal 270C to another component of the IC 150.

In certain applications, the IC 150 may include the digital routing channels 180H-L disposed close to each other to save the chip area. As the channel spacing becomes smaller, a coupling (e.g., an inter-channel coupling with adjacent digital routing channels) may increase and certain activities (e.g., signal transmissions) on certain digital routing channels (so called aggressors, such as the digital routing channels 180J disposed between two adjacent digital routing channels 180I and 180K) may cause certain undesired digital noise (e.g., a temporary glitch) on a signal (e.g., the static digital input signal 260C) that is expected to remain static/quiet. For example, without the inter-channel coupling, the digital output signal 270C may be the same (e.g., a zero volt signal) as the static digital input signal 260C. However, due to the inter-channel coupling from the adjacent digital routing channels 180I and 180K, the digital output signal 270C may include signal glitches 280 (as shown in a block 282), resulting in a false signal.

Certain methods have been used to alleviate the digital noise (e.g., signal glitches caused by inter-channel couplings). For example, spacing out the adjacent digital routing channels may reduce the inter-channel couplings. In some cases, placing repeaters at regular intervals along the digital routing channels may also improve the signal robustness and reduce the inter-channel couplings. However, such methods may reduce efficiency of chip area usage.

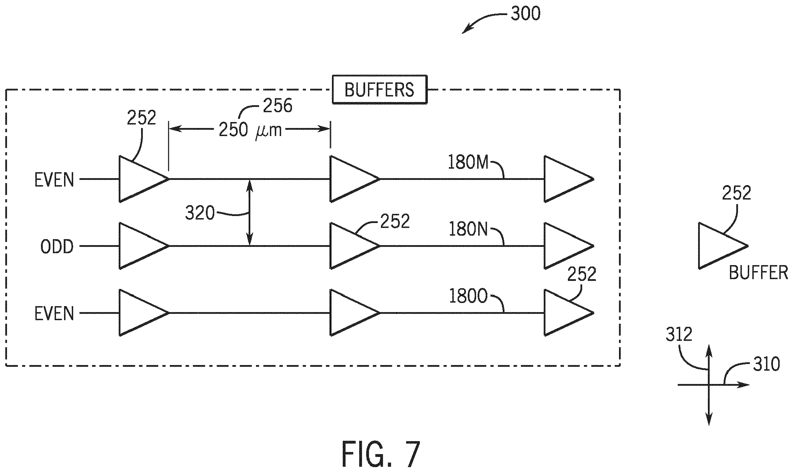

FIG. 7 is a schematic diagram of using a buffering scheme 300 for digital signal transmissions that may be used in the integrated circuits (ICs 150 and 200) of FIGS 4-5. The buffering scheme 300 may include using buffers (e.g., digital buffers, voltage buffers) to isolate an input signal from an output signal. The output signal may mirror the input signal (e.g., without intentionally amplifying or attenuating the input signal). The buffers may have high input impedances such that less current may be drawn, avoiding disturbing an input circuit. The digital buffer may be particularly useful in data transmissions (e.g., to translate voltage pulses between connected systems/devices).

Multiple buffers 252 may be disposed along adjacent digital routing channels 180M, 180N, and 1800 (which may be referred to as Even, Odd, and Even channels). For instance, three buffers 252 may be placed with a constant spacing 256 (e.g., less than 1 millimeter, less than 500 micrometers, such as 250 micrometers, less than 200 micrometers, 1 millimeter or more, and so on) between each other along a longitudinal direction 310 (e.g., parallel to the longer dimension of the adjacent digital routing channels 180M, 180N, and 1800). As mentioned above, a limit (e.g., a threshold spacing or distance) on the minimum spacing between the two adjacent digital routing lines along a transverse direction 312 (e.g., perpendicular or normal to the longitudinal direction 310) may be used to regulate the digital routing channels layout (e.g., the distance 320 between the adjacent digital routing lines 180M and 180N) in the SoC chip (e.g., the SoC chip 102).

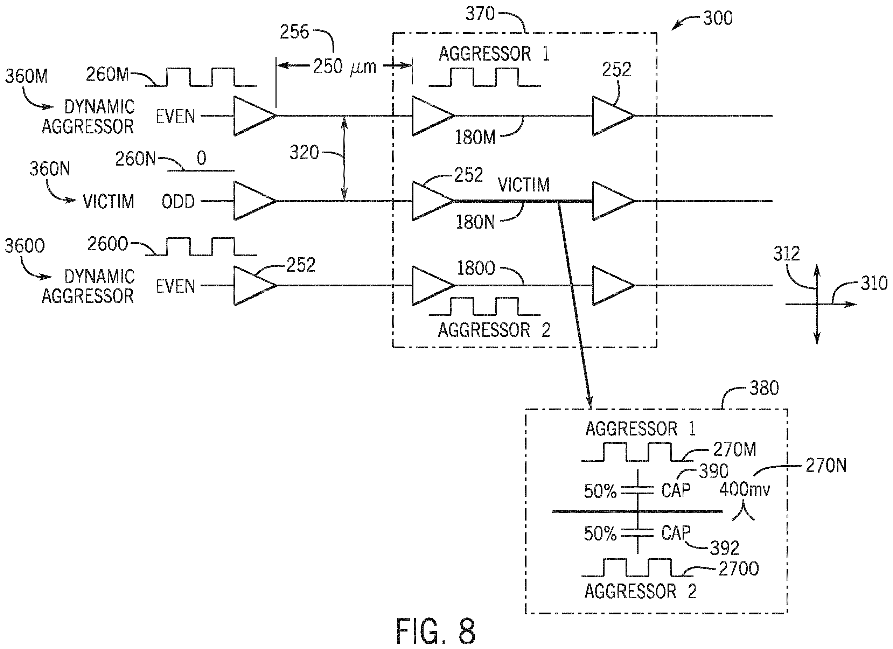

In certain embodiments, the inter-channel coupling (or crosstalk) between a digital routing channel (e.g., digital routing channel 180N) and the adjacent digital routing channels (e.g., digital routing channels 180M, and 1800) may cause certain signal noise (e.g., signal glitches) or errors (e.g., caused by degraded signal integrity due to the inter-channel coupling (or crosstalk) between the adjacent digital routing channels). As an example, FIG. 8 is a schematic diagram of certain signal interferences caused by crosstalk that may occur in the digital signal transmissions using the buffering scheme 300 of FIG. 7. Three buffers 252 may be disposed along each of the adjacent digital routing channels 180M, 180N, and 1800 (referred to as Even, Odd, and Even channels). Each digital routing channel and the corresponding three buffers 252 may be referred to as dynamic aggressor 360M, victim 360N, and dynamic aggressor 3600, respectively. The digital routing channels 180M and 1800 may transmit dynamic digital input signals 260M and 2600, respectively. The digital routing channel 180N placed in between the adjacent digital routing channels 180M and 1800 may transmit static digital input signal 260N (referred to as a victim signal).

A circuit portion 370 (e.g., including a portion of the dynamic aggressors 360M and 3600, and the victim 360N) may be transformed to a circuit diagram 380. The inter-channel couplings may be represented by a coupling capacitance 390 (between the digital routing channels 180M and 180N) and another coupling capacitance 392 (between the digital routing channels 180N and 1800). The circuit portion 370 corresponding to the circuit diagram 380 may generate digital output signals, such as a digital output signal 270M corresponding to the dynamic digital input signals 260M, a digital output signal 270N corresponding to the static digital input signals 260N (victim signal), and a digital output signal 270Q corresponding to the dynamic digital input signals 260Q.

In a worst case scenario, such as the dynamic digital output signals 270M and 2700 are transmitted along the same direction (e.g., along the longitudinal direction 310) and have the same phase, the coupling capacitances 390 and 392 may have noise (e.g., signal glitches) injected to the digital output signal 260N (corresponding to the victim signal) and added up (e.g., up to 400 millivolts). As a result, the higher the glitch is, the lower the noise margin to a next stage is, resulting in rail-to-rail glitches and degraded signal integrity.

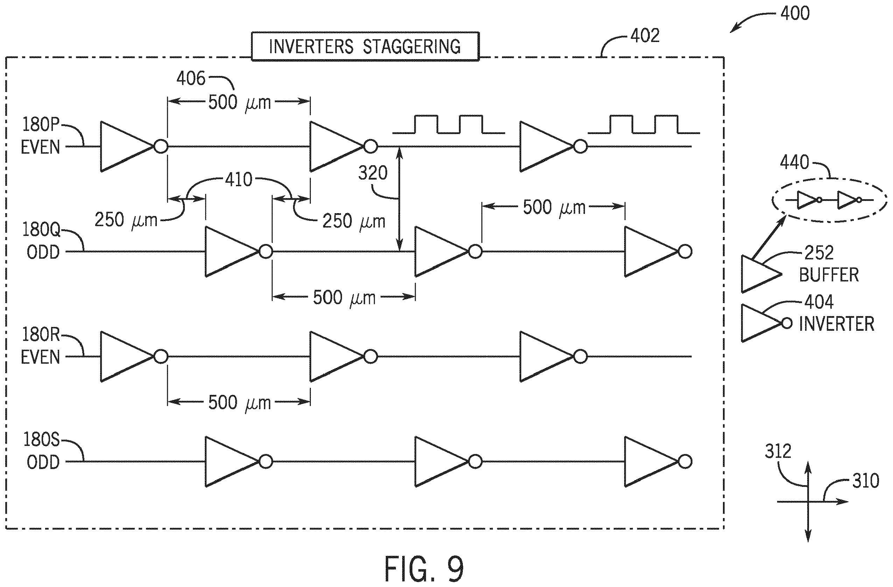

Such undesired signal interference caused by inter-channel coupling (or crosstalk) described above may create challenges for IC designs to maintain desired digital signal qualities (e.g., signal integrity) while improving the efficiency of chip area usage and reducing the power consumption of the ICs in the electronic device 10. In certain embodiments, using integrated circuits (ICs) (e.g., a system-on-chips (SoCs)) integrated with inverter staggering circuits may improve the robustness of digital signals transmitted via the digital routing channels 180 with reduced interferences, resulting in enhanced signal integrity, chip area utilization, power saving, and so on. With this in mind, FIG. 9 is a schematic diagram of a first implementation 400 of a channel crosstalk suppression using inverter-staggering circuits 402 that may solve the signal interferences of FIG. 8.

For instance, three inverters 404 may be placed with a constant spacing 406 (e.g., less than 2 millimeters, less than 1 millimeter, such as 500 micrometers, less than 400 micrometers, 2 millimeters or more, and so on) between each other along the longitudinal direction 310 in each of four digital routing channels (e.g., 180P-S). As mentioned above, a limit (e.g., a threshold spacing or distance) on the minimum spacing between the two adjacent digital routing lines (e.g., digital routing channels 180P and 180Q, or digital routing channels 180Q and 180R, or digital routing channels 180R and 180S) along the transverse direction 312 may be used to regulate the digital routing channels layout (e.g., the distance 320 between the adjacent digital routing lines 180P and 180Q) in the SoC chip (e.g., the SoC chip 102).

In the first implementation 400 of the channel crosstalk suppression, the inverter-staggering circuits 402 may include multiple inverters 404 placed in adjacent digital routing channels (e.g., 180P-S) in a staggered manner. For example, a first set of inverters 404 (e.g., inverters 404 placed in the digital routing channel 180P) may be spaced apart by the constant offset 406 (e.g., 500 micrometers) along the longitudinal direction 310 in the digital routing channel 180P. A second set of inverters 404 (e.g., inverters 404 placed in the digital routing channel 180Q) may be spaced apart by the same constant offset 406 along the longitudinal direction 310 in the digital routing channel 180Q. Each inverter of the first set of inverters 404 do not overlap with each inverter of the second set of inverters 404 in the transverse direction 312. A third set of inverters 404 may be spaced apart (e.g., by 500 micrometers) along the longitudinal direction 310 in the digital routing channel 180R adjacent to the digital routing channel 180Q.

In the inverter-staggering circuits 402, the corresponding inverters 404 in the digital routing channel 180P and 180R are aligned with each other (e.g., two corresponding inverters 404 in different digital routing channels have zero offset along the longitudinal direction 310). The inverters 404 in the digital routing channel 180Q may be disposed in the staggered manner such that each inverter 404 has a constant offset 410 (e.g., half of the constant offset 406, such as less than 1 millimeter, less than 500 micrometers, less than 200 micrometers, 1 millimeter or more, and so on) from a corresponding inverter in the digital routing channel 180P in the longitudinal direction 310, resulting in a three rows of staggered inverters 404 along the three adjacent digital routing channels 180P-R. The inverter-staggering circuits 402 may include any suitable number of digital routing channels 180, where inverters 404 of each routing channel are staggered in this manner (e.g., non-overlapping with adjacent digital routing channels 180). Each of the buffers 252 may perform similar functions as the two inverters in a series connection, as shown in a block 440. Each of the inverters 404 may invert an input signal (e.g., an input signal 442) to generate an output signal 444 having inverted voltages.

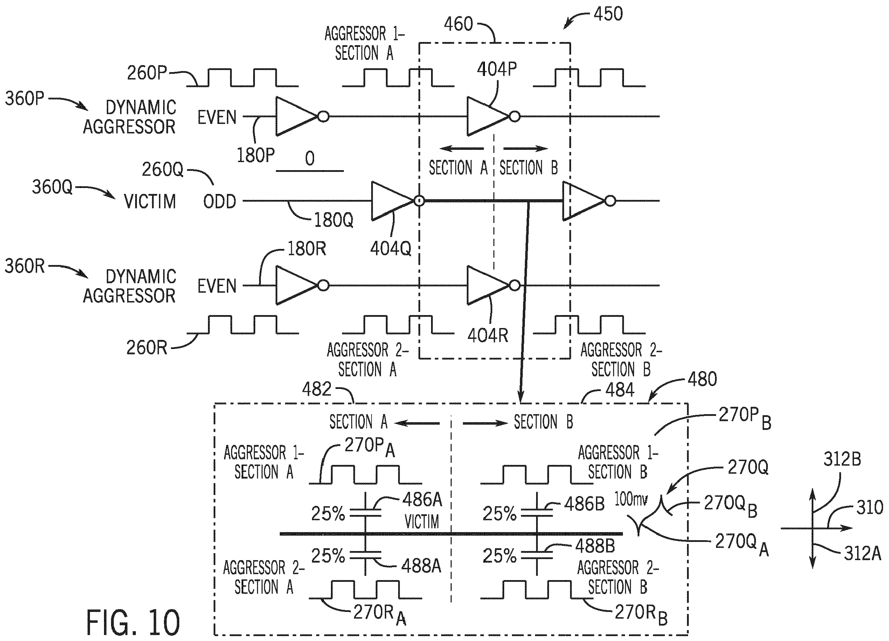

With the foregoing in mind, FIG. 10 is a schematic diagram of transmitted digital signals in the first implementation 400 of the channel crosstalk suppression using the inverter-staggering circuits (e.g., inverter-staggering circuit 402) of FIG. 9. A circuit portion 450 of the inverter-staggering circuit 402 is used to illustrate a signal glitch suppression process (e.g., a signal glitch cancellation). Two inverters 404 may be disposed along each of the adjacent digital routing channels 180P, 180Q, and 180R (referred to as Even, Odd, and Even channels). Each digital routing channel (e.g., the digital routing channel 180P, 180Q, or 180R) and the corresponding two inverters 404 may be referred to as dynamic aggressor 360P, victim 360Q, and dynamic aggressor 360R, respectively. The digital routing channels 180P and 180R may transmit dynamic digital input signals 260P and 260R, respectively. The digital routing channel 180Q placed in between the adjacent digital routing channels 180P and 180Rmay transmit a static digital input signal 260Q (referred to as a victim signal).

A circuit portion 460 (e.g., including a portion of the dynamic aggressors 360P and 360R, and the victim 360Q) may be transformed to a circuit diagram 480. The circuit diagram 480 may include two sections, such as section 482 (referred to as a section A) and section 484 (referred to as a section B), representing a first circuit portion of the circuit diagram 480 (corresponding to an intermediate input portion upstream of or before the inverters 404P and 404R on the digital routing channels 180P and 180R) and a second circuit portion of the circuit diagram 480 (corresponding to an intermediate output portion downstream of or after the inverters 404P and 404R). The inter-channel couplings may be represented by a coupling capacitance 486A (between portions of the digital routing channels 180P and 180Q within the section 482), a coupling capacitance 486B (between portions of the digital routing channels 180P and 180Q within the section 484), a coupling capacitance 488A (between portions of the digital routing channels 180Q and 180R within the section 482), and a coupling capacitance 488B (between portions of the digital routing channels 180Q and 180R within the section 484).

The circuit portion 460 corresponding to the circuit diagram 480 may receive intermediate digital input signals 270P_{A} and 270R_{A}, and generate intermediate digital output signals 270P_{B} and 270R_{B} via the digital routing channels 180P and 180R, respectively. The intermediate digital output signals 270P_{B} and 270R_{B} are inverted by the inverters 404P and 404R with respect to the intermediate digital input signals 270P_{A} and 270R_{A}, respectively. Half of the coupling capacitances, including the coupling capacitances 486A and 488A have noise (e.g., signal glitch) injected to the victim signal (static digital input signal 260Q) in one direction 312A, resulting in an intermediate digital signal 270Q_{A}. The other half of the coupling capacitances, including the coupling capacitances 486B and 488B have noise (e.g., signal glitch) injected to the victim signal (static digital input signal 260Q) in the other direction 312B, resulting in the other intermediate digital signal 270Qa. The intermediate digital signals 270Q_{A} and 270Q_{B} are opposite to each other, resulting in an intermediate digital output signal 270Q having cancelled noise. Moreover, when the injected noise (e.g., signal glitch) is relatively low, there is no sustained rail-to-rail glitch propagating through the digital routing channels 180Q, thereby maintaining the signal integrity.

The use of the inverter-staggering circuits (e.g., inverter-staggering circuit 402) may result in an increased distance through which a digital signal may be routed while maintaining the signal integrity and preventing certain functional failures (e.g., caused by degraded signal integrity due to the interferences between the adjacent digital routing channels). For example, when the integrated circuit includes certain digital routing channels positioned within a proximity from each other, the transmitted digital signals via the digital routing channels may interfere with each other. The interferences (e.g., inter-channel coupling (or crosstalk)) may increase in certain conditions, such as when signals transmitted via adjacent channels (e.g., aggressors 360P and 360R) are in the same direction and/or in the same or similar phase. Such interferences may result in undesired artifacts (e.g., noises including temporary glitches) on the transmitted signals. By placing the inverters (e.g., inverters 404P, 404Q, and 404R) on adjacent digital routing channels (e.g., 180P, 180Q, and 180R) in the staggered manner, the interferences from the adjacent digital routing channels may cancel each other, resulting in noise-free signal transmissions.

Furthermore, with the increased distance, various components (e.g., logic circuits, intellectual property (IP) cores) of the integrated circuit may be placed with sparser distance from each other, resulting in improved chip area utilization and power saving. Moreover, the digital signals may be routed closer to each other (e.g., in comparison to integrated circuits using buffering scheme (e.g., buffering scheme 300 of FIG. 7), resulting in improved chip area utilization (e.g., routing area).

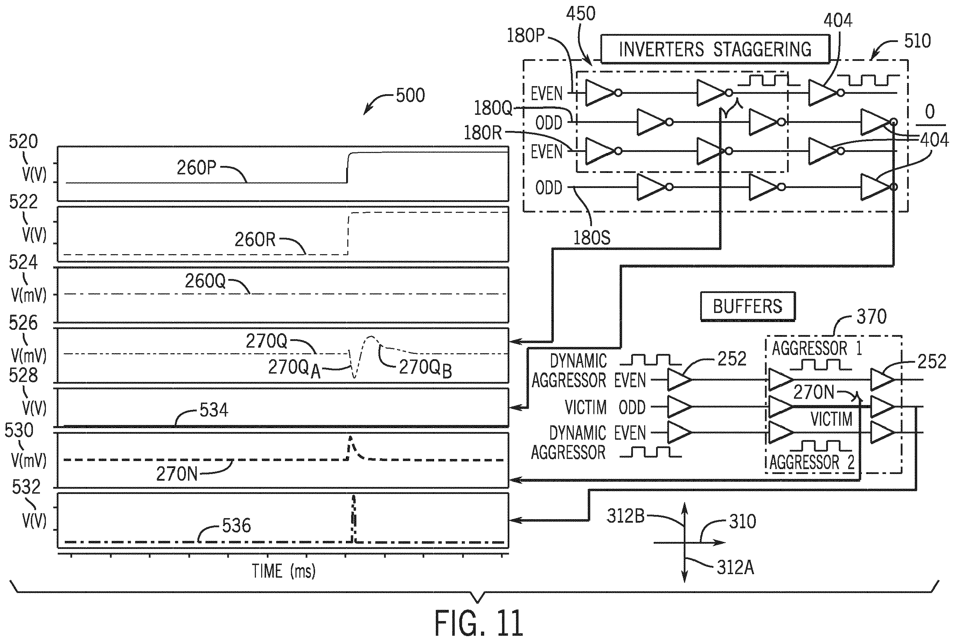

FIG. 11 is a schematic diagram of signal integrity testing examples 500 using a circuit 510 including the inverter-staggering circuits 402 of FIG. 9 and additional inverters 404 (e.g., subsequent to the inverter-staggering circuits 402). The signal integrity testing examples 500 include the dynamic digital input signals 260P and 260R (as shown in sections 520 and 522, respectively) and static digital input signals 260Q (as shown in a section 524). In response to the digital input signals 260P, 260Q, and 260R, the circuit 510 generates the digital output signal 270Q via the digital routing channel 180Q. As mentioned above, the half of the coupling capacitances (e.g., 486A and 488A) have noise (e.g., signal glitch) injected to the victim signal (static digital input signal 260Q) in the direction 312A, resulting in the intermediate digital signal 270Q_{A} (as shown in a section 526). The other half of the coupling capacitances (e.g., 486B and 488B) have noise (e.g., signal glitch) injected to the victim signal (static digital input signal 260Q) in the other direction 312B, resulting in the other intermediate digital signal 270Q_{B} (as shown in the section 526). The intermediate digital signals 270Q_{A} and 270Q_{B} are opposite to each other, resulting in the intermediate digital output signal 270Q having cancelled noise (as shown in a section 526).

Moreover, the circuit 510 generates a digital output signal 534 (as shown in a section 528) via the digital routing channel 180Q in response to the intermediate digital output signal 270Q. The digital output signal 534 has no sustained rail-to-rail glitch propagating through the digital routing channels 180Q, thereby maintaining the signal integrity. In comparison, the signal integrity testing examples 500 include testing results using the buffering scheme (e.g., buffering scheme 300 of FIG. 7), as shown in sections 530 and 532.

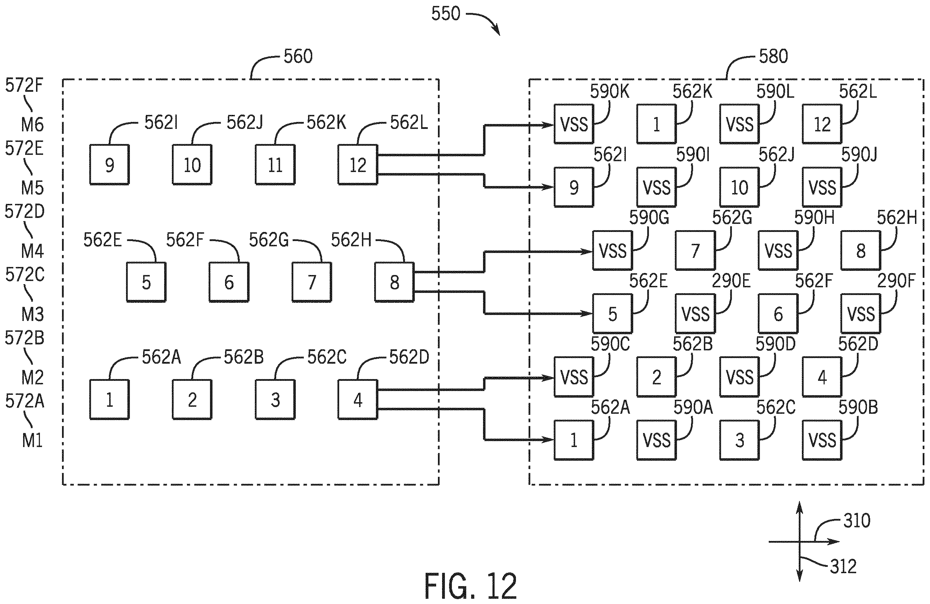

In addition to the first implementation 400 of the channel crosstalk suppression using inverter-staggering circuits 402, the integrated circuits (ICs) (e.g., a system-on-chips (SoCs)) may use other implementations to improve the robustness of digital signals transmitted via the digital routing channels (e.g., channels 180) with reduced interferences, resulting in enhanced signal integrity, chip area utilization, power saving, and so on. In certain embodiments, the integrated circuits (ICs) may integrate with coaxial shielding of digital routing channels. For example, FIG. 12 is a schematic diagram of a second implementation 550 of the channel crosstalk suppression using coaxial shielding that may solve the signal interferences of FIG. 8.

In the second implementation 550 of the channel crosstalk suppression, the integrated circuit (ICs) may include the coaxial shielding to increase an isolation between the digital signal lines (e.g., digital routing channels) disposed in the adjacent layers (e.g., semiconductor layers), resulting in increased signal transmission distances of the digital signals. Therefore, the longer distances the digital signals are transmitted, the greater saving of the chip area and power consumption are obtained.

In certain digital routing integrated circuit (ICs), such as the digital routing IC 560, digital signal lines, such as digital signal lines 562A-L, are disposed in a serial sequence in corresponding layers. For example, the digital signal lines 562A-D may be disposed sequentially within a layer 572A (referred to as M1), the digital signal lines 562E-H may be disposed sequentially within a layer 572C (referred to as M3), and the digital signal lines 562I-L may be disposed sequentially within a layer 572E (referred to as M15). As mentioned above, digital signals (victim signals) transmitted via the digital signal lines 562E-H (referred to as victim signal lines) disposed within the layer 572C (M3) may have injected noise (e.g., signal glitch) from adjacent digital signal lines 562I-L and 562A-D disposed within the adjacent layers 572E and 572A, respectively. As a result, the higher the injected noise is, the lower the noise margin to a next stage is, resulting in rail-to-rail glitches and degraded signal integrity.

In a coaxial shielding digital routing integrated circuit (IC) 580, the digital signal lines 562A-L disposed in the adjacent layers (e.g., 572A-E) may be rearranged into an interdigitate pattern with added ground or negative supply voltage (Vss) lines 590A-L (e.g., zero-volt lines or silent lines) across the adjacent digital routing channels. For example, a respective Vss line (e.g., 590A) may be disposed between two successive, adjacent, or neighboring digital signal lines (e.g., 562A and 562C) in the longitudinal direction 310. Additionally, or alternatively, another respective Vss line (e.g., 590C) may be disposed between two successive, adjacent, or neighboring digital signal lines (e.g., 562A and 562E) in the transverse direction 312. In this way, interdigitated digital signal lines and Vss lines are disposed in the coaxial shielding digital routing integrated circuit (IC) 580, such that each transmitted digital signal may effectively "see" or be affected by more coupling capacitances to the adjacent Vss lines (that do not increase signal crosstalk) and less coupling capacitances to the adjacent digital signal lines. Therefore, each transmitted signal may have more coupling capacitances to the adjacent Vss lines and less coupling capacitances to the adjacent digital signal lines, resulting in reduced signal crosstalk, enhanced signal integrity, chip area utilization, power saving, and so on.

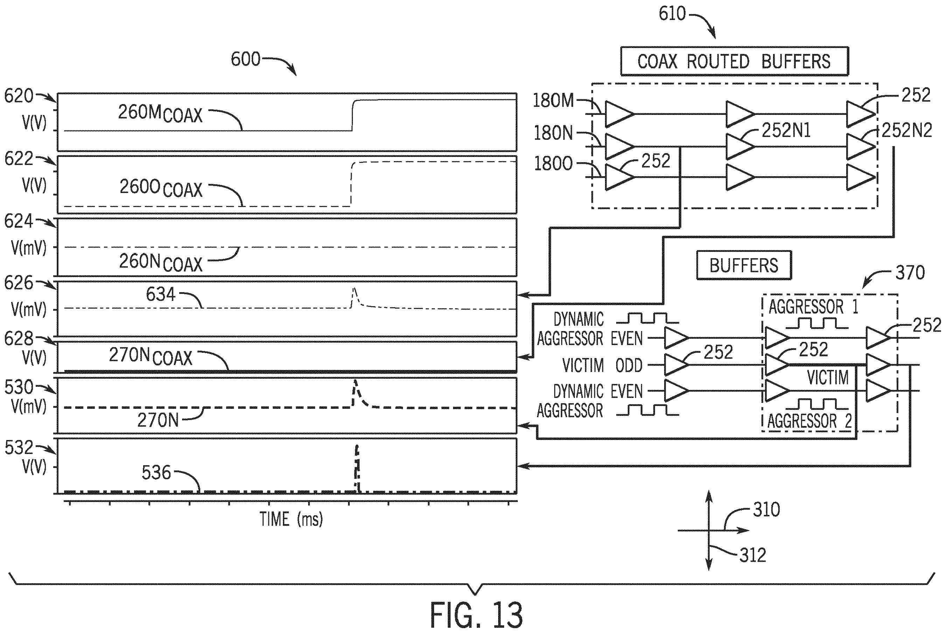

FIG. 13 is a schematic diagram of signal integrity testing examples 600 using a coaxial shielding circuits 610 having the coaxial shielding of FIG. 12. The signal integrity testing examples 600 include the dynamic digital input signals 260M_{COAX} and 2600_{COAX} (as shown in sections 620 and 622, respectively) and static digital input signal 260N_{COAX} (as shown in a section 624). In response to the digital input signals 260M_{COAX}, 260N_{COAX}, and 2600_{COAX}, the coaxial shielding circuits 610 generate an intermediate digital signal 634 (before a buffer 252N1) and the digital output signal 270 N_{COAX} (after a buffer 252N2) via the digital routing channel 180N.

As mentioned above, in the worst case scenario, such as the dynamic digital input signals 260M_{COAX} and 2600_{COAX} being transmitted along the same direction (e.g., along the longitudinal direction 310) and having the same phase, the coupling capacitances (e.g., between the digital routing channels 180M and 180N, and between the digital routing channels 180N and 1800) may have noise (e.g., signal glitches) injected to the intermediate digital signal 634 and added up (e.g., up to 400 millivolts), as shown in a section 626. However, with the coaxial shielding used in the coaxial shielding circuits 610 (e.g., similar to the interdigitated digital signal lines and Vss lines disposed in the coaxial shielding digital routing integrated circuit (IC) 580), each transmitted digital signal may effectively "see" or be affected by more coupling capacitances to the adjacent Vss lines (that do not increase signal crosstalk) and less coupling capacitances to the adjacent digital signal lines. As a result, each transmitted signal may have more coupling capacitances to the adjacent Vss lines and less coupling capacitances to the adjacent digital signal lines, resulting in cancelled or reduced noise in the digital output signal 270N_{COAX}, as shown in a section 628. In this way, the coaxial shielding circuits 610 may have the reduced signal crosstalk, enhanced signal integrity, chip area utilization, power saving, and so on.

Moreover, the digital output signal 270N_{COAX} has no sustained rail-to-rail glitch propagating through the digital routing channels 180N, thereby maintaining the signal integrity. In comparison, the signal integrity testing examples 600 include testing results using the buffering scheme (e.g., buffering scheme 300 of FIG. 7), as shown in sections 530 and 532. In the illustrated case scenario (e.g., the dynamic digital input signals 260M_{COAX} and 2600_{COAX} are transmitted along the same direction and have the same phase), the coupling capacitances (e.g., coupling capacitances 390 and 392) may have noise (e.g., signal glitches) injected to the digital output signal 270N (corresponding to the victim signal) and added up (e.g., up to 400 millivolts), as shown in the section 530. As a result, the higher the glitch is, the lower the noise margin to a next stage is, resulting in a final digital output signal 536 having rail-to-rail glitches and degraded signal integrity, as shown in the section 532.

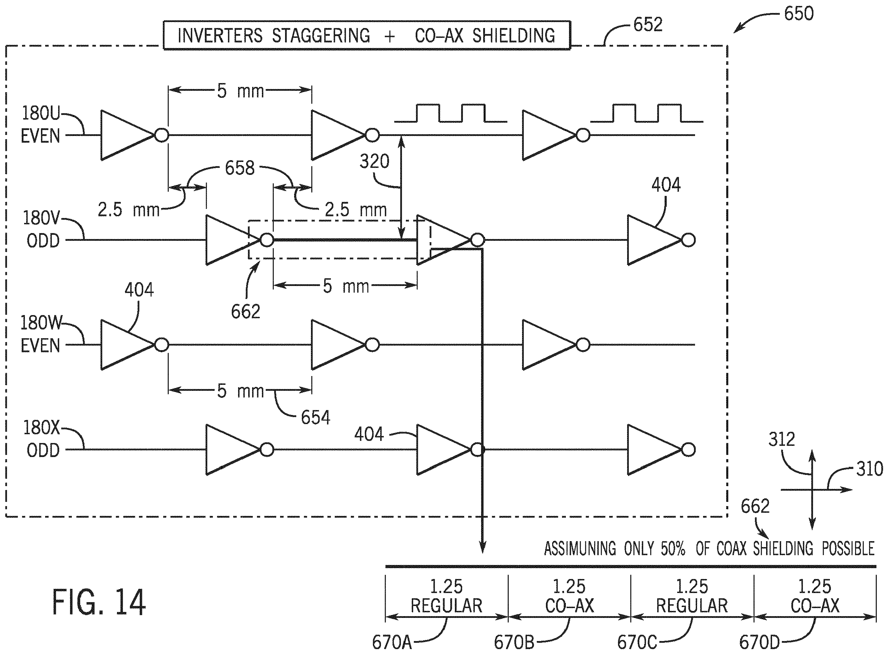

In certain embodiments, using integrated circuits (ICs) (e.g., system-on-chips (SoCs)) integrated with the inverter staggering circuits (as shown in FIG. 9) and the coaxial shielding (as shown in FIG. 12) may further improve the robustness of digital signals transmitted via the digital routing channels 180 with reduced interferences, resulting in enhanced signal integrity, chip area utilization, power saving, and so on. With this in mind, FIG. 14 is a schematic diagram of a third implementation 650 of the channel crosstalk suppression using a combination of inverter-staggering circuits (e.g., inverter-staggering circuits 402 of FIG. 9) and coaxial shielding circuits (e.g., coaxial shielding circuits 610 of FIG. 12).

In the third implementation 650 of the channel crosstalk suppression, an integrated circuit (IC) 652 may include multiple digital routing channels, such as digital routing channels 180U-X and multiple inverters 404. The inverters 404 may be disposed in each digital routing channel with a constant offset 654 (e.g., less than 20 millimeters, less than 10 millimeters, such as 5 millimeters, less than 4 millimeters, 20 millimeters or more, and so on) in the longitudinal direction 310. In the integrated circuit (IC) 652, the corresponding inverters 404 in the digital routing channel 180U and 180W are aligned with each other (e.g., two corresponding inverters 404 in different digital routing channels have zero offset along the longitudinal direction 310). The inverters 404 in the digital routing channel 180V may be disposed in the staggered manner such that each inverter 404 has a constant offset 658 (e.g., half of the constant offset 654, such as less than 10 millimeters, less than 5 millimeters, such as 2.5 millimeters, less than 2 millimeters, 10 millimeters or more, and so on) from a corresponding inverter 404 in the digital routing channel 180U or 180W in the longitudinal direction 310, resulting in a three rows of staggered inverters 404 along the three adjacent digital routing channels 180U-W. The integrated circuit (IC) 6 may include any suitable number of digital routing channels 180, where inverters 404 of each routing channel are staggered in this manner (e.g., non-overlapping with adjacent digital routing channels 180).

In certain embodiments, the integrated circuit (IC) 652 may include partially coaxial shielded digital routing channels (e.g., the coaxial shielding may not be applied to certain part of a digital routing channel due to certain practical circuit layout limitations). For example, the digital routing channel 180V may include a portion 662 (e.g., having a length of 5 millimeters) that is partially shielded, such as sections 670A and 670C (each having a length of 1.25 millimeters) have no coaxial shielding applied, while sections 670B and 670D (each having a length of 1.25 millimeters) have coaxial shielding applied. That is, the portion 662 has 50% coaxial shielding applied.

Using the combination of inverter-staggering circuits and coaxial shielding circuits, the integrated circuit (IC) 652 may have further increased distance (e.g., in comparison to the inverter staggering circuits 402 of FIG. 9 or the coaxial shielding circuits 610 of FIG. 12) through which a digital signal may be routed while maintaining the signal integrity and preventing certain functional failures (e.g., caused by degraded signal integrity due to the interferences between the adjacent digital routing channels). As mentioned previously, when an integrated circuit includes digital routing channels (e.g., digital routing channels 180) positioned within a proximity from each other, the transmitted digital signals via the digital routing channels may interfere with each other. Such interferences (e.g., caused by the inter-channel coupling or crosstalk) may increase in certain conditions (e.g., when digital signals transmitted via adjacent channels are in the same direction and/or in the same or similar phase. The interferences may result in undesired artifacts (e.g., signal glitches) on the transmitted signals. By applying the coaxial shielding (fully or partially) to digital routing channels 180 combined with placing the adjacent digital routing channels (e.g., 180U, 180V, 180W, and 180X) in the staggered manner, each transmitted signal may have more coupling capacitances to the adjacent Vss lines and less coupling capacitances to the adjacent digital signal lines, resulting in cancelled (noise-free) or reduced noise in the digital output signals. In this way, the integrated circuit (IC) 652 may have noise-free signal transmissions, enhanced signal integrity, chip area utilization, power saving, and so on.

Using the combination of inverter-staggering circuits and coaxial shielding circuits, the integrated circuit (IC) 652 may have further increased distances (e.g., in comparison to the first implementation 400 of FIG. 9 and the second implementation 550 of FIG. 12) through which a digital signal may be routed while maintaining the signal integrity and preventing the interferences between the adjacent digital routing channels, resulting in further improved chip area utilization and power saving.

For instance, in certain cases, signals transmitted in integrated circuits (ICs) using the buffering scheme (e.g., buffering scheme 300 of FIG. 7) with conventional routings may have noise violations (e.g., injected noise caused by inter-channel couplings) when the buffer spacing is equal or larger than 250 micrometers. Using the inverter staggering (e.g., the inverter staggering circuits 402 of FIG. 9), the integrated circuit (IC) 652 may transmit digital signals for a distance longer than 250 micrometers without noise violations. Moreover, using the coaxial shielding (e.g., coaxial shielding circuits 610 of FIG. 12), the integrated circuit (IC) 652 may have further improved signal robustness (e.g., by increasing the shielding between adjacent digital signal lines). Therefore, by combining the inverter staggering and the coaxial shielding, the integrated circuit (IC) 652 may have longer distances that the digital signal lines may be routed without using the buffers. Furthermore, with the increased distance, various components (e.g., logic circuits, intellectual property (IP) cores) of the integrated circuit (IC) 652 may be placed with sparser distance from each other, resulting in improved chip area utilization and power saving. Moreover, the digital signals may be routed closer to each other (e.g., in comparison to integrated circuits using buffering scheme, resulting in improved chip area utilization (e.g., routing area).

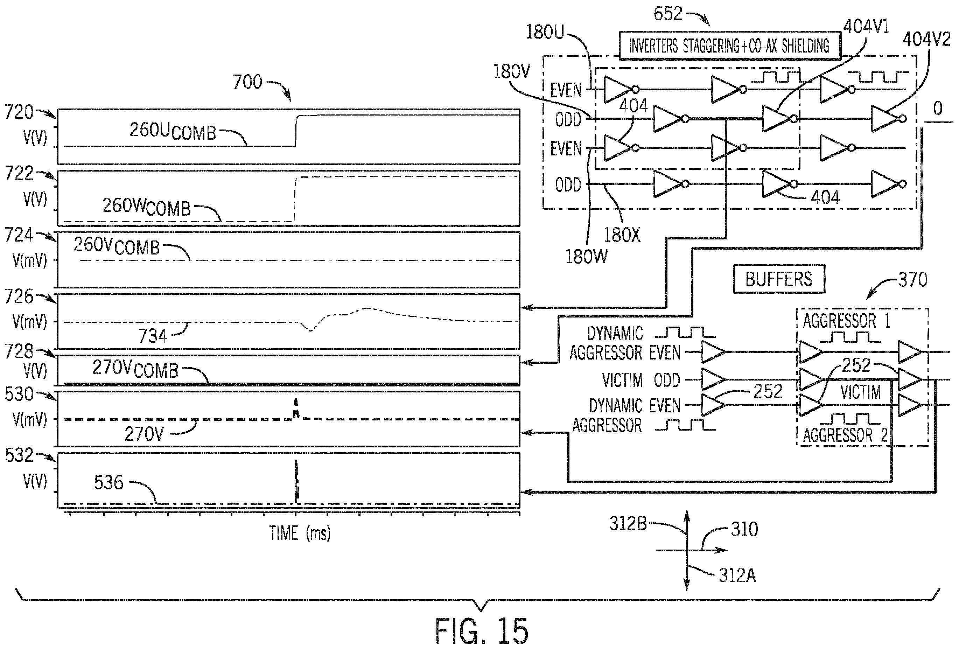

FIG. 15 is a schematic diagram of signal integrity testing examples 700 using the integrated circuit (IC) 652 including the combination of the inverter-staggering circuits and the coaxial shielding of FIG. 14. The signal integrity testing examples 700 include dynamic digital input signals 260U_{COMB} and 260W_{COMB} (as shown in sections 720 and 722, respectively) and static digital input signal 260V_{COMB} (as shown in a section 724). In response to the digital input signals 260U_{COMB}, 260V_{COMB}, and 260W_{COMB}, the integrated circuit (IC) 652 generates an intermediate digital signal 734 (before an inverter 404V1) and a digital output signal 270 V_{COMB} (after an inverter 404V2) via the digital routing channel 180V.

As mentioned above, in the worst case scenario, such as the dynamic digital input signals 260U_{COMB} and 260W_{COMB} being transmitted along the same direction (e.g., along the longitudinal direction 310) and having the same phase, the coupling capacitances (e.g., between the digital routing channels 180U and 180V, and between the digital routing channels 180V and 180W) may have noise (e.g., signal glitches) injected to the intermediate digital signal 734 and added up, as shown in a section 726. However, by applying the coaxial shielding (fully or partially) to digital routing channels 180 combined with placing the adjacent digital routing channels (e.g., 180U, 180V, 180W, and 180X) in the staggered manner, each transmitted signal may have more coupling capacitances to the adjacent Vss lines and less coupling capacitances to the adjacent digital signal lines, resulting in cancelled or reduced noise in the digital output signal 270V_{COMB}, as shown in a section 728. In this way, the integrated circuit (IC) 652 may have noise-free signal transmissions, enhanced signal integrity, chip area utilization, power saving, and so on.

Moreover, the digital output signal 270V_{COMB} has no sustained rail-to-rail glitch propagating through the digital routing channels 180V, thereby maintaining the signal integrity. In comparison, the signal integrity testing examples 700 include testing results using the buffering scheme (e.g., buffering scheme 300 of FIG. 7), as shown in sections 530 and 532. In the illustrated case scenario (e.g., the dynamic digital input signals 260M_{COMB} and 260O_{COMB} are transmitted along the same direction and have the same phase), the coupling capacitances (e.g., coupling capacitances 390 and 392) may have noise (e.g., signal glitches) injected to the digital output signal 270N (corresponding to the victim signal) and added up (e.g., up to 400 millivolts), as shown in the section 530. As a result, the higher the glitch is, the lower the noise margin to a next stage is, resulting in a final digital output signal 536 having rail-to-rail glitches and degraded signal integrity, as shown in the section 532.

The specific embodiments described above have been shown by way of example, and it should be understood that these embodiments may be susceptible to various modifications and alternative forms. It should be further understood that the claims are not intended to be limited to the particular forms disclosed, but rather to cover all modifications, equivalents, and alternatives falling within the spirit and scope of this disclosure.

The techniques presented and claimed herein are referenced and applied to material objects and concrete examples of a practical nature that demonstrably improve the present technical field and, as such, are not abstract, intangible or purely theoretical. Further, if any claims appended to the end of this specification contain one or more elements designated as "means for [perform]ing [a function]..." or "step for [perform]ing [a function]...," it is intended that such elements are to be interpreted under 35 U.S.C. 112(f). However, for any claims containing elements designated in any other manner, it is intended that such elements are not to be interpreted under 35 U.S.C. 112(f).

It is well understood that the use of personally identifiable information should follow privacy policies and practices that are generally recognized as meeting or exceeding industry or governmental requirements for maintaining the privacy of users. In particular, personally identifiable information data should be managed and handled so as to minimize risks of unintentional or unauthorized access or use, and the nature of authorized use should be clearly indicated to users.

### NUMBERED STATEMENTS OF THE INVENTION

1. An integrated circuit comprising:
   a plurality of circuit components;
   a plurality of routing channels coupled to the plurality of circuit components;
   a first plurality of inverters disposed on a first routing channel of the plurality of routing channels in a longitudinal direction; and
   a second plurality of inverters disposed on a second routing channel of the plurality of routing channels in the longitudinal direction, each inverter of the second plurality of inverters non-overlapping with each inverter of the first plurality of inverters in a transverse direction.
2. The integrated circuit of statement 1, wherein the plurality of circuit components comprises a system-on-chip (SoC) chip comprising a central processing unit (CPU), a memory, and one or more peripherals comprising a graphics processing unit (GPU), neural network circuitry, and a transceiver.
3. The integrated circuit of statement 2, wherein the plurality of circuit components comprises an auxiliary chip coupled to the system-on-chip (SoC) chip, wherein the auxiliary chip comprises an additional transceiver and a network interface configured to provide communications between the system-on-chip (SoC) chip and one or more integrated circuits comprising additional one or more system-on-chip (SoC) chips or additional one or more auxiliary chips.
4. The integrated circuit of statement 1, comprising a third plurality of inverters disposed on a third routing channel of the plurality of routing channels in the longitudinal direction, each inverter of the third plurality of inverters overlapping with each inverter of the first plurality of inverters in the transverse direction.
5. The integrated circuit of statement 4, wherein the first plurality of inverters, the second plurality of inverters, and the third plurality of inverters forms a staggered pattern to reduce inter-channel interferences introduced from the first routing channel and the third routing channel on the second routing channel.
6. The integrated circuit of statement 4, wherein the first plurality of inverters is uniformly distributed on the first routing channel with a constant spacing between two adjacent inverters of the first plurality of inverters.
7. The integrated circuit of statement 6, wherein the third plurality of inverters is uniformly distributed on the third routing channel with the constant spacing between two adjacent inverters of the third plurality of inverters.
8. An integrated circuit comprising:
   a plurality of circuit components;
   a plurality of routing channels coupled to the plurality of circuit components extending in a longitudinal direction; and
   a plurality of ground or negative supply signal lines, wherein a respective ground or negative supply signal line of the plurality of ground or negative supply signal lines is disposed between two or more routing channels s of the plurality of routing channels in the longitudinal direction or a transverse direction.
9. The integrated circuit of statement 8, wherein the plurality of routing channels and the plurality of ground or negative supply signal lines are disposed within a first layer of the integrated circuit extending in the longitudinal direction and the transverse direction.
10. The integrated circuit of statement 9, comprising a first additional plurality of routing channels coupled to the plurality of circuit components and a first additional plurality of ground or negative supply signal lines extending in the longitudinal direction within a second layer of the integrated circuit adjacent to the first layer in the transverse direction.
11. The integrated circuit of statement 10, comprising a second additional plurality of routing channels coupled to the plurality of circuit components and a second additional plurality of ground or negative supply signal lines extending in the longitudinal direction within a third layer of the integrated circuit adjacent to the first layer in the transverse direction and opposite to the second layer.
12. The integrated circuit of statement 11, wherein the plurality of routing channels and the plurality of ground or negative supply signal lines, the first additional plurality of routing channels and the first additional plurality of ground or negative supply signal lines, and the second additional plurality of routing channels and the additional plurality of ground or negative supply signal lines form an interdigitate pattern to reduce inter-channel interferences introduced from the first additional plurality of routing channels and the second additional plurality of routing channels on the plurality of routing channels.
13. The integrated circuit of statement 8, wherein a respective routing channel of the plurality of routing channels is disposed between two ground or negative supply signal lines of the plurality of ground or negative supply signal lines.
14. The integrated circuit of statement 8, wherein a respective routing channel of the plurality of routing channels is disposed between a first and a second ground or negative supply signal lines of the plurality of ground or negative supply signal lines within a first layer of the integrated circuit extending in the longitudinal direction and the transverse direction, wherein the respective routing channel of the plurality of routing channels is disposed between a third ground or negative supply signal line within a second layer of the integrated circuit and a fourth ground or negative supply signal line within a third layer of the integrated circuit, and wherein the first layer is between and parallel to the second layer and the third layer.
15. An electronic device comprising:
   a processor;
   a transceiver;
   a plurality of routing channels coupling the processor to the transceiver;
   a first plurality of inverters disposed on a first routing channel of the plurality of routing channels in a longitudinal direction;
   a second plurality of inverters disposed on a second routing channel of the plurality of routing channels in the longitudinal direction, each inverter of the second plurality of inverters non-overlapping with each inverter of the first plurality of inverters in a transverse direction; and
   a plurality of ground or negative supply signal lines, wherein a respective ground or negative supply signal line of the plurality of ground or negative supply signal lines is disposed between two or more routing channels s of the plurality of routing channels in the longitudinal direction or a transverse direction.
16. The electronic device of statement 15, wherein the first routing channel and the second routing channel of the plurality of routing channels are disposed within a same semiconductor layer of the electronic device.
17. The electronic device of statement 16, wherein a respective ground or negative supply signal line of the plurality of ground or negative supply signal lines is disposed between two routing channels of the plurality of routing channels.
18. The electronic device of statement 15, wherein the first routing channel and the second routing channel of the plurality of routing channels are disposed within two semiconductor layers of the electronic device, wherein the two semiconductor layers are parallel to each other.
19. The electronic device of statement 18, wherein a respective ground or negative supply signal line of the plurality of ground or negative supply signal lines is disposed between two or more routing channels of the plurality of routing channels, wherein the two or more routing channels comprise the first routing channel and the second routing channel.
20. The electronic device of statement 19, wherein the respective ground or negative supply signal line is disposed within a semiconductor layer between the two semiconductor layers of the electronic device.

## Claims

1. An integrated circuit comprising:
a plurality of circuit components;
a plurality of routing channels coupled to the plurality of circuit components;
a first plurality of inverters disposed on a first routing channel of the plurality of routing channels in a longitudinal direction; and
a second plurality of inverters disposed on a second routing channel of the plurality of routing channels in the longitudinal direction, each inverter of the second plurality of inverters non-overlapping with each inverter of the first plurality of inverters in a transverse direction.

2. The integrated circuit of claim 1, wherein the plurality of circuit components comprises a system-on-chip (SoC) chip comprising a central processing unit (CPU), a memory, and one or more peripherals comprising a graphics processing unit (GPU), neural network circuitry, and a transceiver.

3. The integrated circuit of claim 2, wherein the plurality of circuit components comprises an auxiliary chip coupled to the system-on-chip (SoC) chip, wherein the auxiliary chip comprises an additional transceiver and a network interface configured to provide communications between the system-on-chip (SoC) chip and one or more integrated circuits comprising additional one or more system-on-chip (SoC) chips or additional one or more auxiliary chips.

4. The integrated circuit of claim 1, comprising a third plurality of inverters disposed on a third routing channel of the plurality of routing channels in the longitudinal direction, each inverter of the third plurality of inverters overlapping with each inverter of the first plurality of inverters in the transverse direction.

5. The integrated circuit of claim 4, wherein the first plurality of inverters, the second plurality of inverters, and the third plurality of inverters forms a staggered pattern to reduce inter-channel interferences introduced from the first routing channel and the third routing channel on the second routing channel.

6. The integrated circuit of claim 4, wherein the first plurality of inverters is uniformly distributed on the first routing channel with a constant spacing between two adjacent inverters of the first plurality of inverters.

7. The integrated circuit of claim 6, wherein the third plurality of inverters is uniformly distributed on the third routing channel with the constant spacing between two adjacent inverters of the third plurality of inverters.

8. The integrated circuit of claim 1, comprising:
a plurality of ground or negative supply signal lines, wherein a respective ground or negative supply signal line of the plurality of ground or negative supply signal lines is disposed between two or more routing channels of the plurality of routing channels in the longitudinal direction or a transverse direction.

9. The integrated circuit of claim 8, wherein the plurality of routing channels and the plurality of ground or negative supply signal lines are disposed within a first layer of the integrated circuit extending in the longitudinal direction and the transverse direction.

10. The integrated circuit of claim 9, comprising a first additional plurality of routing channels coupled to the plurality of circuit components and a first additional plurality of ground or negative supply signal lines extending in the longitudinal direction within a second layer of the integrated circuit adjacent to the first layer in the transverse direction.

11. The integrated circuit of claim 10, comprising a second additional plurality of routing channels coupled to the plurality of circuit components and a second additional plurality of ground or negative supply signal lines extending in the longitudinal direction within a third layer of the integrated circuit adjacent to the first layer in the transverse direction and opposite to the second layer.

12. The integrated circuit of claim 11, wherein the plurality of routing channels and the plurality of ground or negative supply signal lines, the first additional plurality of routing channels and the first additional plurality of ground or negative supply signal lines, and the second additional plurality of routing channels and the additional plurality of ground or negative supply signal lines form an interdigitate pattern to reduce inter-channel interferences introduced from the first additional plurality of routing channels and the second additional plurality of routing channels on the plurality of routing channels.

13. The integrated circuit of claim 8, wherein a respective routing channel of the plurality of routing channels is disposed between two ground or negative supply signal lines of the plurality of ground or negative supply signal lines.

14. The integrated circuit of claim 8, wherein a respective routing channel of the plurality of routing channels is disposed between a first and a second ground or negative supply signal lines of the plurality of ground or negative supply signal lines within a first layer of the integrated circuit extending in the longitudinal direction and the transverse direction, wherein the respective routing channel of the plurality of routing channels is disposed between a third ground or negative supply signal line within a second layer of the integrated circuit and a fourth ground or negative supply signal line within a third layer of the integrated circuit, and wherein the first layer is between and parallel to the second layer and the third layer.
